**Europäisches Patentamt**

**European Patent Office**

**Office européen des brevets**

(19)

(11) Numéro de publication: **0 016 910**
**B1**

(12) **FASCICULE DE BREVET EUROPEEN**

(45) Date de publication du fascicule du brevet: **13.04.83**

(21) Numéro de dépôt: **80100327.8**

(22) Date de dépôt: **23.01.80**

(51) Int. Cl.³: **C 30 B 23/04,**
C 30 B 25/04, H 01 L 21/20

(54) **Procédé de formation de vides épitaxiaux dans des structures cristallines.**

(30) Priorité: **05.03.79 US 17230**

(43) Date de publication de la demande:
**15.10.80 Bulletin 80/21**

(45) Mention de la délivrance du brevet:
**13.04.83 Bulletin 83/15**

(84) Etats contractants désignés:
**DE FR GB**

(56) Documents cités:
**US - A - 3 884 733**

**JOURNAL OF CRYSTAL GROWTH, Vol. 45, No.
1, 1 décembre 1978
Amsterdam
N. MATSUDA et al. "Vapour-phase Ipitaxial
Growth of ZnS on GaP" pages 192 à 197**

(73) Titulaire: **International Business Machines
Corporation
Armonk, N.Y. 10504 (US)**

(72) Inventeur: **Marinace, John Carter
2096 Van Cortland Circle
Yorktowns Heights, NY 10598 (US)**

(74) Mandataire: **Gallois, Gérard
COMPAGNIE IBM FRANCE Département de
Propriété Industrielle
F-06610 La Gaude (FR)**

Courier Press, Leamington Spa, England.

Procédé de formation de vides épitaxiaux dans des structures cristallines

## Domaine Technique

La présente invention concerne la fabrication de dispositifs de très faibles dimensions de l'ordre de 3 à 100 microns pouvant être utilisés dans certains cas comme tunnels de refroidissement, dans des dispositifs semi-conducteurs à transistor comme dispositifs d'émission lumineuse, pour assurer diverses fonctions optiques, comme buses à jet d'encre, comme électrode de charge, comme muliplicateur électronique de canaux et comme cathode pour tube cathodique. Les vides sont triangulaires et entourées par du matériau monocristallin.

## Etat de la Technique Antérieure

La formation de structures semi-conductrices épitaxiales dans lesquelles des plans de croissance préférentielle sont utilisés, est bien connue dans l'art antérieur. A titre d'exemple, on peut se reporter aux brevets US—A— No. 3 884 733 et 3 855 690 qui présentent des ensembles de dispositifs de forme particulière utilisés à des fins optiques qui sont formés par la croissance d'un matériau épitaxial sur un substrat en utilisant un plan cristallographique à croissance préférentielle et présentant une face optique souhaitable. Cependant, jusqu'à maintenant, la région produite par le plan de croissance préférentielle a été exposée.

## Expose de l'Invention

Les procédés de croissance du cristal tel que le dépôt chimique en phase vapeur, impliquent une dépendance du taux de croissance par rapport aux différents plans cristallographiques de la structure cristalline produite. La croissance exécutée sur un substrat orienté de façon que deux plans cristallographiques à croissance préférentielle se coupent provoque l'apparition d'un tunnel ou d'un vide dans la structure cristalline produite, lorsque la surface du substrat, sur laquelle la croissance est effectuée, est recouverte d'un matériau "résistant", c'est-à-dire inhibiteur de croissance, délimitant le vide.

Dans certaines structures cristallines comme les composés inter-métalliques III—V, la différence du taux de croissance entre un plan cristallographique et un autre, peut atteindre un facteur de 100.

La largeur des tunnels ou vides produits peut être de l'ordre de 3 à 100 microns et ces tunnels ou vides sont utiles dans de nombreux cas, par exemple lorsqu'un matériau dur ou chimiquement inerte de cette dimension est recherché ou lorsque, le matériau étant du type semi-conducteur, diverses propriétés d'émission lumineuse sont communiquées à la structure permettant ainsi aux tunnels d'être utilisés à des fins de transmission optique.

## Breve Description des Figures

La Figure 1 représente schématiquement la relation existant entre trois plans cristallographiques, qui conditionne la pratique de la présente invention.

La Figure 2 est une vue en coupe d'une structure tunnel épitaxiale.

La Figure 3 est une vue en coupe d'une structure tunnel épitaxiale comprenant un jonction p—n.

La Figure 4 est une vue en coupe d'une structure tunnel épitaxiale ayant une section de forme différente.

## Description d'un Mode de Réalisation de l'Invention

Le substrat est choisi avec une orientation cristallographique et sur ce substrat devra être exécutée la croissance de la structure cristalline telle que deux plans à taux de croissance élevé se couperont.

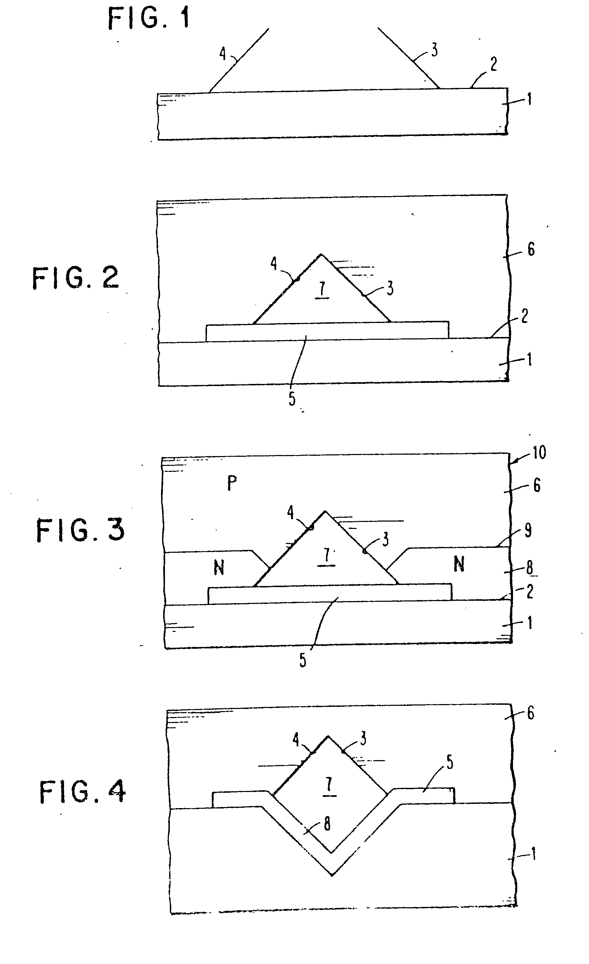

La Figure 1 représente le substrat 1 sous la forme d'un matériau mono-cristallin présentant une orientation cristallographique telle que la face 2 sur laquelle la croissance doit être exécutée, sera coupée par deux plans cristallographiques 3 et 4 qui vont croître depuis cette face 2. Dans ce cas si la croissance est maintenue pendant suffisamment longtemps, les plans 3 et 4 finissent par se couper. Lorsque les plans 2, 3 et 4 présentent une croissance préférentielle, l'intersection est atteinte rapidement.

La Figure 2 représente un substrat 1 comportant un matériau de définition de forme et d'interdiction de croissance 5 qui consiste généralement en un matériau résistant d'interdiction de croissance d'une forme appropriée, placé sur la surface 2. La surface 2 est d'une orientation cristallographique telle que les plans préférentiels 3 et 4 se couperont, formant ainsi une structure fermée 6 comportant un vide ou tunnel 7. Le matériau résistant 5 appliqué au substrat 1 peut donner n'importe quelle forme au tunnel 7.

Bien que la présente invention puisse être appliquée à n'importe quel matériau cristallin pouvant avoir deux plans de croissance préférentielle en intersection, on notera que les composés semi-conducteurs inter-métalliques des catégories III—V et II—VI facilitent une croissance préférentielle lorsque la face 2 du substrat présente une orientation cristallographique de [100] et que les plans 3 et 4 en intersection sont des plans cristallographiques présentant une orientation de [111B].

Le substrat 1 peut être fabriqué en un composé de la catégorie III—V tel que de l'arseniure de gallium, avec une bande étroite de l'ordre de 3 à 100 microns représentée sous la forme de l'élément 5 en $SiO_2$, $Al_2O_3$ ou Mo, par exemple.

Le matériau cristallin 6 croît alors par application des procédés classiques de croissance en phase vapeur en utilisant une source de GaAs et du HCl comme agent de transport.

Le HCl + $H_2$ est passé sur des éléments de matériau source GaAs à 850°C pour le transporter au substrat qui est maintenu à 750°C.

Un substrat sous la forme d'une pastille de GaAs dont l'orientation est décalée nominalement de 3° par rapport à un plan cristallographique [100] vers le plan cristallographique [110], est chimiquement polie avec du méthanol-$Br_2$ et reçoit un film de 200 nm de $SiO_2$ ou de $Al_2O_3$. La bande 5 est disposée sur le film d'oxyde selon une certaine configuration en utilisant un matériau photo-résistant, l'axe de la bande étant disposé suivant l'une des directions cristallographiques [110] sur les plans cristallographiques [100], c'est-à-dire les plans qui forment un angle aigu avec la bande 5 et lorsque le matériau épitaxial est formé, le vide est finalement recouvert. Plus la bande d'oxyde 5 est large, plus le passage du vide ou du tunnel est important. Des tunnels à côtés de 3 à 100 microns sont généralement obtenus.

On notera que la bande 5 s'étend au-delà de l'intersection des plans 3 et 4 avec la surface 2. Ceci a pour but de tenir compte du fait que lorsque les plans à croissance lente se propagent les uns vers les autres, les plans à croissance rapide ferment le vide ou tunnel 7. La sélection de la largeur de la bande 5 doit être fait en tenant compte de cette caractéristique.

Les composés III—V d'arseniure de gallium et de phosphure de gallium et les composés II—VI de séléniure de zinc sont préférés parmi les composés inter-métalliques semi-conducteurs.

Dans le cas du composé III—V d'arseniure de gallium, le GaAs de dépôt ne forme pas de noyau sur le molybdène; en conséquence des bandes de Mo peuvent également être utilisés dans un tel cas, en dehors des autres exemples de dioxyde de silicium et d'oxyde d'aluminium. Le Mo est inerte aux réactions de dépôt chimique halogène en phase vapeur.

Un procédé empirique pour choisir les directions cristallographiques [110] sur la surface de substrat cristallographique [100] d'arseniure de gallium donné à titre d'exemple, a été imaginé. Une pastille de GaAs portant un film d'oxyde sur sa surface polie, est immergée dans une solution de 3:1:1:$H_2O$:$H_2O_2$:$NH_4OH$ pendant approximativement 3 minutes. Partout où un trou d'épingle existe dans l'oxyde, une figure d'attaque de configuration allongée se forme. Si les bandes d'oxyde sont parallèles à l'axe longitudinal de la figure d'attaque, on obtient la formation des tunnels de la présente invention. Cependant, lorsque les bandes sont perpendiculaires à l'axe longitudinal, des gorges se forment. Si aucun trou d'épingle ne peut être trouvé dans l'oxyde, les figures d'attaque sur le fond de la pastille sont tournées de 90° par rapport à celles du haut et peuvent être utilisées comme guides. Si les axes des bandes sont disposés dans chacune des directions ⟨100⟩ de la surface {100}, on obtiendra des parois verticales.

A titre d'exemple de cristal élémentaire, on peut également former des tunnels ou des vides dans le silicium en orientant des bandes étroites selon l'une des directions [110] sur une surface cristallographique [100] du substrat. La différence des taux de croissance n'est pas aussi prononcée dans les cristaux élémentaires que dans les cristaux inter-métalliques. Comme indiqué dans le brevet US—A No. 3 884 733 cité précédemment, le plan cristallographique [113] est l'un des plans de croissance les plus rapides dans le silicium.

De plus, les tunnels de la présente invention, outre leur utilisation pour la réalisation de formes en matériau dur, présentent également un avantage particulier dans le domaine des semi-conducteurs lorsqu'une jonction p—n est incorporée dans la structure.

Dans la Figure 3, on a fait croître sur la surface 2 du substrat 1, une région n 8 qui forme une jonction p—n 9 avec une région p 10 de façon que les bords de la jonction p—n 9 soient exposés dans les plans 3 et 4 dans la cavité 7; ce qui donne des propriétés d'émission lumineuse au tunnel.

Etant donné que le tunnel peut être effilé en amincissant à la fabrication le matériau résistant 5, on peut aisément réaliser des sources ponctuelles de lumière qui pourront être électriquement modulées. Ainsi, on peut obtenir une grande variété de structures électro-optiques fabriquées avec une grande précision.

Il est évident que des tunnels ou des cavités de section autre que triangulaire peuvent être obtenus par exemple, en ménageant des gorges dans le substrat. Un tel exemple pour du silicium ou de l'arseniure de gallium est illustré par la Figure 4. Les mêmes références numériques ont été conservées dans la Figure 4 et une gorge 8 est ménagée dans le substrat orienté [100] et la bande 5 est déposée dans la gorge 8 et en position adjacente à celle-ci.

On a donc décrit un procédé de formation de vides en forme de tunnel dans un matériau cristallin en provoquant l'intersection de deux plans de croissance préférentielle pour pratiquer un vide dans le cristal croissant.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Procédé de formation de vides épitaxiaux dans des structures cristallines, caractérisé en ce qu'il comprend:

la formation d'un substrat cristallin dont une surface de croissance présente une première orientation cristallographique et a deux plans de croissance préférentielle qui coupent ladite surface et sont en intersection à une distance finie de ladite surface,

la formation d'une configuration de matériau résistant, inhibiteur de croissance, délimitant ledit vide, sur ledit substrat, et

la croissance épitaxiale d'un cristal sur le substrat suivant lesdits plans jusqu'à ce que l'intersection se produise.

2. Procédé selon la revendication 1, caractérisé en ce que ladite configuration de matériau résistant, inhibiteur de croissance, est composée d'un matériau qui est SiO$_2$ ou Al$_2$O$_3$ ou Mo.

3. Procédé selon la revendication 1 ou 2, caractérisé en ce qu'il comprend en outre:

la formation d'une jonction p—n ledit cristal que l'on a fait croître.

4. Procédé selon l'une des revendications 1 à 3, caractérisé en ce que ladite configuration de matériau résistant, inhibiteur de croissance, est en forme de pointe pour réaliser ainsi une source lumineuse ponctuelle.

5. Procédé selon l'une des revendications 1 à 4, caractérisé en ce que ladite structure cristalline est composée de GaAs.

6. Procédé selon l'une des revendications 1 à 4, caractérisé en ce que ladite structure cristalline est composée de GaP.

7. Procédé selon l'une des revendications 1 à 4, caractérisé en ce que ladite structure cristalline est composée de ZnSe.

8. Procédé selon l'une des revendications 1 à 4, caractérisé en ce que ladite structure cristalline est composée de silicium.

9. Procédé selon l'une des revendication 1 à 8, caractérise en ce que ladite orientation de la surface du substrat correspond au plan cristallographique [100].

**Patentansprüche**

1. Verfahren zum Ausbilden von epitaktischen Hohlräumen in kristallinen Strukturen, dadurch gekennzeichnet, daß es einschließt:

das Bilden eines kristallinen Substrates, dessen eine Wachstumsoberfläche eine erste kristallographische Orientierung aufweist und zwei Vorzugs-Wachstumsebenen hat, die diese Oberfläche schneiden und sich in einer endlichen Entfernung von dieser Oberfläche im Schnittpunkt treffen,

das Bilden eines Musters aus einem wachstumshindernden Resistmaterial auf dem Substrat zur Begrenzung des Hohlraumes, und

das epitaktische Aufwachsen eines Kristalls auf dem Substrat entlang den Ebenen, bis sich der Schnittpunkt ergibt.

2. Verfahren nach Anspruch 1, dadurch gekennzeichnet, daß das Muster aus wachstumshinderndem Resistmaterial aus einem Material besteht, das SiO$_2$, Al$_2$O$_3$ oder Mo ist.

3. Verfahren nach Anspruch 1 oder 2, dadurch gekennzeichnet, daß es ferner einschließt:

das Bilden eines p—n Überganges in dem so gewachsenen Kristall.

4. Verfahren nach einem der Ansprüche 1 bis 3, dadurch gekennzeichnet, daß das Muster aus wachstumshinderndem Resistmaterial eine Spitze bildet, um so eine punktförmige Lichtquelle zu schaffen.

5. Verfahren nach einem der Ansprüche 1 bis 4, dadurch gekennzeichnet, daß die kristalline Struktur aus GaAs besteht.

6. Verfahren nach einem der Ansprüche 1 bis 4, dadurch gekennzeichnet, daß die kristalline Struktur aus GaP besteht.

7. Verfahren nach einem der Ansprüche 1 bis 4, dadurch gekennzeichnet, daß die kristalline Struktur aus ZnSe besteht.

8. Verfahren nach einem der Ansprüche 1 bis 4, dadurch gekennzeichnet, daß die kristalline Struktur aus Silicium besteht.

9. Verfahren nach einem der Ansprüche 1 bis 8, dadurch gekennzeichnet, daß die Orientierung der Substratoberfläche der kristallographischen Ebene ⟨100⟩ entspricht.

**Claims**

1. A method of forming epitaxial cavities in crystalline structures, characterized in that it comprises:

forming a crystalline substrate, one growth surface of which has a first crystallographic orientation and two preferential growth planes which cross said surface and intersect at a finite distance from said surface,

forming on said substrate a pattern of growth-inhibiting resist material delineating said cavity, and

epitaxially growing a crystal on the substrate following said planes until the intersection is obtained.

2. A method according to claim 1, characterized in that said pattern of growth-inhibiting resist material is composed of a material which is SiO$_2$, Al$_2$O$_3$ or Mo.

3. A method according to claim 1 or 2, characterized in that it further comprises:

forming a p—n junction in said crystal having been grown.

4. A method according to any one of claims 1 to 3, characterized in that said pattern of growth-inhibiting resist material is point-shaped so as to obtain a pin-point light source.

5. A method according to any one of claims 1 to 4, characterized in that said crystalline structure is composed of GaAs.

6. A method according to any one of claims 1 to 4, characterized in that said crystalline structure is composed of GaP.

7. A method according to any one of claims 1 to 4, characterized in that said crystalline structure is composed of ZnSe.

8. A method according to any one of claims 1 to 4, characterized in that said crystalline structure is composed of silicon.

9. A method according to any one of claims 1 to 8, characterized in that said orientation of the surface of the substrate corresponds to the crystallographic plane [100].

0016910

FIG. 1

FIG. 2

FIG. 3

FIG. 4